Europäisches Patentamt

European Patent Office

Office européen des brevets

(11) Publication number: **0 134 680 B1**

# EUROPEAN PATENT SPECIFICATION

(45) Date of publication of patent specification: **18.12.91** (51) Int. Cl.⁵: **C30B 15/26**

(21) Application number: **84305036.0**

(22) Date of filing: **24.07.84**

(30) Priority: **29.07.83 JP 138821/83**

(43) Date of publication of application:
**20.03.85 Bulletin 85/12**

(45) Publication of the grant of the patent:
**18.12.91 Bulletin 91/51**

(84) Designated Contracting States:
**DE FR GB IT**

(56) References cited:
**FR-A- 2 071 788**
**GB-A- 1 405 447**

**IBM TECHNICAL DISCLOSURE BULLETIN, vol.
19, no. 3, August 1976, pages 869,870, New
York, US; E.M.HULL et al.: "Monitoring diameter of semiconductor crystals during automated growth"**

**INSTRUMENTS & CONTROL SYSTEMS, vol.
47, no. 7, July 1974, pages 26,28,30; "The
leading edge..."**

(54) Apparatus for manufacturing a single crystal.

(73) Proprietor: **KABUSHIKI KAISHA TOSHIBA
72, Horikawa-cho Saiwai-ku
Kawasaki-shi Kanagawa-ken(JP)**

(72) Inventor: **Washizuka, Syoichi c/o Patent Division
K.K. Toshiba 1-1, Shibaura 1-chome
Minato-ku Tokyo 105(JP)**
Inventor: **Watanabe, Masayuki c/o Patent Division
K.K. Toshiba 1-1, Shibaura 1-chome
Minato-ku Tokyo 105(JP)**

(74) Representative: **Freed, Arthur Woolf et al
MARKS & CLERK 57-60 Lincoln's Inn Fields
London WC2A 3LS(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to an apparatus for manufacturing a single crystal by the Czochralski method. More particularly, it relates to an apparatus which can automatically shape a single crystal, while being pulled up from a crucible.

Most of the single crystals of silicon are made by the Czochralsky method in which a seed crystal is dipped in molten silicon in a crucible, a Dash's neck is formed of the growing single crystal, and the crystal is pulled up at a controlled speed while the temperature of the molten silicon is being controlled and while the crystal is growing further. In this method, the crystal is made to grow until it has a desired diameter and then is pulled up while maintaining this diameter. Hithereto, whether or not the crystal may have a desired diameter largely depends on the skill of the workers. That is, until its diameter increases to a desired value, the crystal is first pulled at a speed lower than that when a trunk of the crystal is formed. When a skilled worker determines, by using or not using a scale, that the diameter of the crystal has become close to the desired value, he begins to pull it faster to prevent it from growing thicker. Thereafter, he lowers the pull-up speed to a predetermined value, thus forming the trunk of the crystal. The diameter of the trunk may be adjusted by PID control.

With the conventional method which much depends on the skills of a worker, it is difficult to produce single crystals of the same shape; single crystals of different diameters or single crystals with lowered shoulders may be produced. Further, each crystal made by this method may have thick and thin portions. If the crystals are subjected to an excessive PID control test they will probably have varying diameters, they may also have striations or an uneven impurity concentration distribution. Even if they have the same diameter, they must be ground when they are too thick or they must be discarded when they are too thin. Both grinding and discarding reduces the yield.

A process of controlling the diameter of single crystals being made by the Czochralski method is disclosed in Japanese Patent Disclosure No. 55-130895. This process uses a ITV camera to monitor how the diameter of a single crystal being pulled up from the crucible changes with time. The rate of diameter change is used to control the speed of pulling up the crystal and to adjust the electric power supply for heating the crucible, so as to control the diameter of the final product.

This method has a drawback, however. Since the diameter of the product is controlled in accordance with the rate that its diameter increases (i.e., the speed of the crystal growth), it is difficult to desirably shape the shoulder of the crystal since the shoulder is formed while the speed is rapidly changing. Further, the larger the diameter, the more slowly the growth catches up with the changes in manufacturing conditions.

Documents "IBM Technical Disclosure Bulletin" Vol. 19 No. 3, August 1976 at pages 869 and 870 and "Instruments and Control Systems" Vol. 47 No. 7 July 1974 at pages 26, 28 and 30 both describe automated apparatus for manufacturing single crystals by a Czochralski method. In both cases the automation is effected by feedback processes.

The present invention provides an apparatus as defined in claim 1 of the appended claims, which enables the disadvantages of the prior apparatus to be mitigated.

The apparatus of the invention can automatically manufacture a single crystal with a shoulder of the desired shape and with a trunk of a predetermined diameter. The crystal made by the apparatus has no striation and is of a high quality. The apparatus needs no skilled labor. Further, it can make single crystals in a short time with a high reproducibility. It helps to reduce the material loss as compared with the known apparatus, and to enhance the production yield. In short, it increases productivity since it automatically controls the shape of the crystal being produced.

Embodiments of the invention will now be described by way of example only and with reference to the accompanying drawings, in which :

Fig. 1 is a block diagram of an apparatus according to the invention;

Fig. 2 is a block diagram illustrating how the device of Fig. 1 operates:

Fig. 3 is a flow chart showing how the device automatically operates; and

Figs. 4 and 5 are graphs showing the control mode of the device.

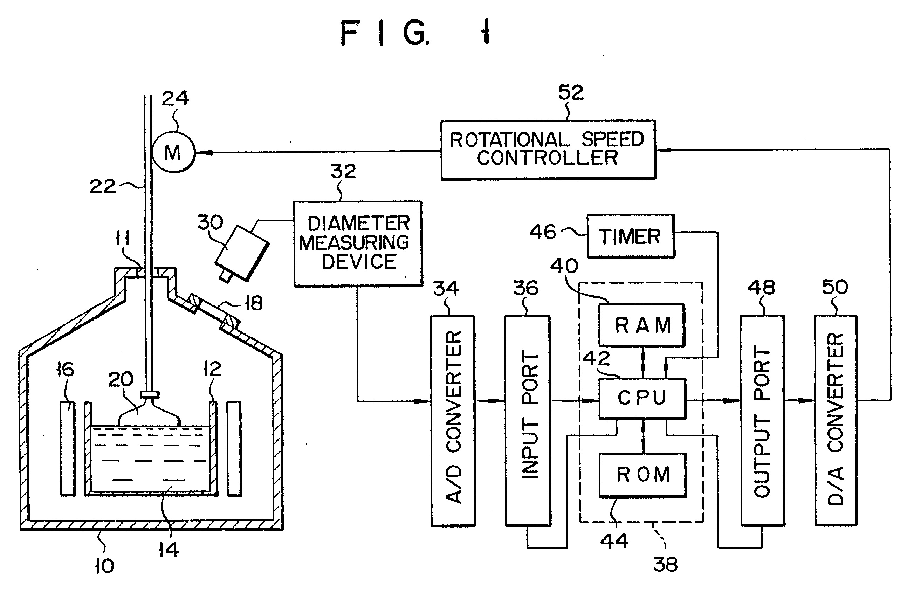

Fig. 1 schematically shows an apparatus of the invention for manufacturing a single crystal. The apparatus comprises a chamber 10, a crucible 12 provided in the chamber 10 and filled with molten silicon 14, and an annular heater 16 placed in the chamber 10 around the crucible 12. The chamber 10 has an opening 11 made in its top portion. A rod 22 vertically extends in the chamber 10 through this opening 11. It is slidably supported by a support (not shown and provided outside the chamber 10). It may be moved up and down by a motor 24. A seed crystal is attached to the lower end of the rod 22. The rod 22 is lowered while being rotated, thereby dipping the rotating seed crystal in the molten silicon 14. It is then lifted, thereby pulling up the crystal 20 grown on the seed crystal. A window 18 is made in the upper portion of the chamber 10. An industrial TV (ITV) camera 30 is so positioned as to monitor the crystal 20 through the window 18. The output signal of the camera 30 is input to a diameter measuring device 32, which measures the diameter D of the crystal 20.

The output signal of the diameter measuring device 32 is converted to a digital signal by an A/D converter 34. The digital signal is supplied to, and latched by, an input port 36. The output data from the input port 36 is input to a microcomputer 38.

The microcomputer 38 has a CPU (central processing unit) 42, a RAM (random-access memory) 40 connected to CPU 42, and a ROM (read-only memory) 44 also connected to CPU 42. A timer 46 is connected to determine the one-cycle period of the CPU 42. ROM 44 stores a program for controlling the CPU 42. The CPU 42 therefore functions according to this program during its one-cycle period determined by the timer 46. More specifically, it receives the data showing the diameter D, exchanges data with the RAM 40 and calculates the most suitable speed at which to pull up the single crystal 20. The data representing this speed is supplied via an output port 48 to a D/A converter 50 and is converted to an analog signal. The analog signal is input to a rotational speed controller 52, which controls the rotational speed of the motor 24 so as to lift the rod 22 at the speed calculated by the microcomputer 38.

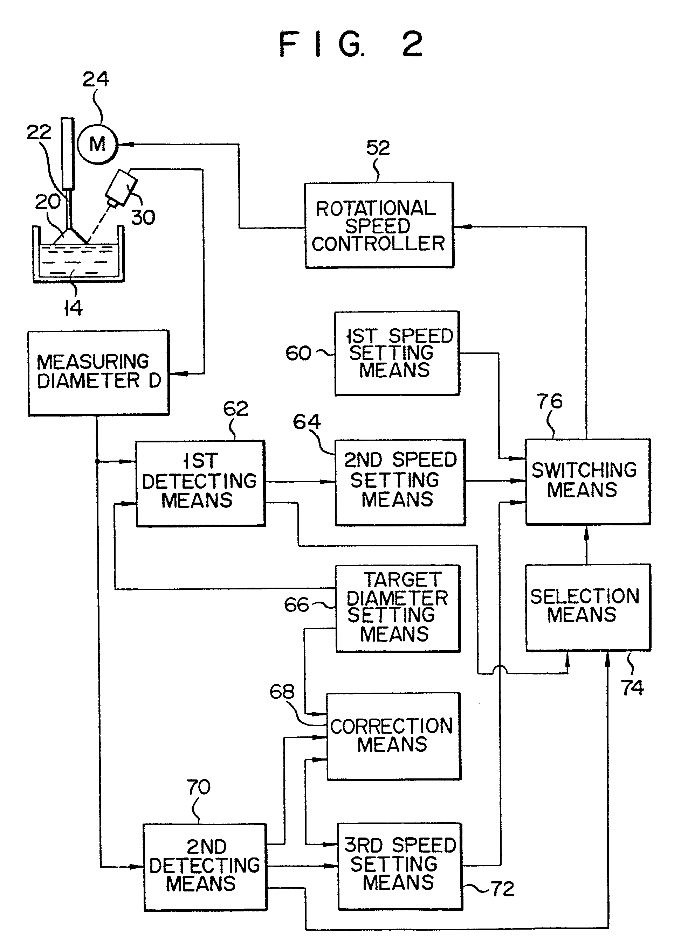

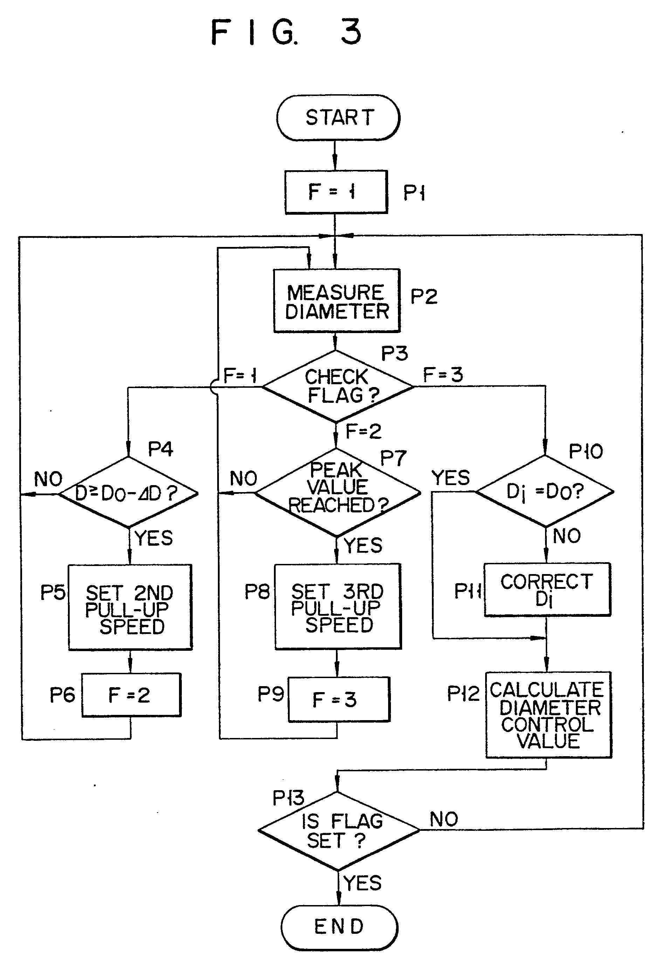

It will now be explained how the microcomputer 38 functions with reference to Fig. 2 and Fig. 3 (flow chart). The CPU 42 operates as follows in accordance with the program stored in ROM 44, while exchanging data with RAM 40.

The output from the diameter measuring device 32 is supplied to first and second detecting means 62 and 70 through the A/D converter 34 and input port 36. The first detecting means 62 has been given data showing a target diameter $D_0$ for the crystal 20 by a target diameter setting means 66. When the measured diameter D exceeds $D_0$-$\Delta D$ (where $\Delta D$ is the deviation allowance), the first detecting means 62 generates a first detection signal and supplies it to a second speed setting means 64, which outputs data representing a second pull-up speed $V_2$. This speed data is supplied to a switching means 76. The output data of a first speed setting means 60, which represents a first pull-up speed $V_1$, is also supplied to the switching means 76. The second detection means 70 supplies a second detection signal to a third speed setting means 72 when it detects that the measured diameter reaches the peak value $\overline{D}$. Upon receipt of the second detection signal, the third speed setting means 72 produces data showing a third pull-up speed $V_3$. The diameter previously measured by the diameter measuring device 32 is used as the peak value $\overline{D}$ when it is greater than the measured diameter D. The third speed setting means 72 controls the speed $V_3$ so that the diameter D of the crystal 20 may equal the control target value $D_i$. The initial value $V_0$ for the speed $V_3$ has been given to the third speed setting means 72. When the measured diameter D is different from the diameter $D_i$, the third speed setting means 72 calculates the deviation allowance $\Delta V$ and then the output speed data $V_3$ (= $V_0$ + $\Delta V$). $\Delta V$ is calculated by the PID (proportional integral derivative) control method. $D_i$ is input by operating a target value correction means 68 and is input to the third speed setting means 72. The initial input data from the correction means 68 is the peak value $\overline{D}$. The means 68 varies gradually the control target value $D_i$ until it has a value nearly equal to the target diameter $D_0$, when the former is different from the latter. For instance, it calculates the control target value Di(n) by correcting the previous control target value Di(n-1) as follows:

$$Di(n) = Di(n-1) - K\{Di(n-1) - D_0\} \qquad (1)$$

where K is a constant of proportion (0 < K < 1). Di is corrected at the end of every control cycle preset by the timer 46 and gradually approaches the target diameter $D_0$. The pull-up speed $V_3$ set by the third speed setting means 72 is supplied to the switching means 76. The detection signals generated by the first and second detecting means 62, 70 are also input to a selection means 74. At first the means 76 inputs the speed $V_1$ set by the first speed setting means 60 to a rotational speed controller 52. Upon receipt of the first detection signal, the selection means 74 actuates the switching means 76, thereby supplying speed $V_2$ from the second speed setting means 64 to the controller 52. Upon receipt of the second detection signal, it supplies speed $V_3$ from the third speed setting means 72 to the controller 52.

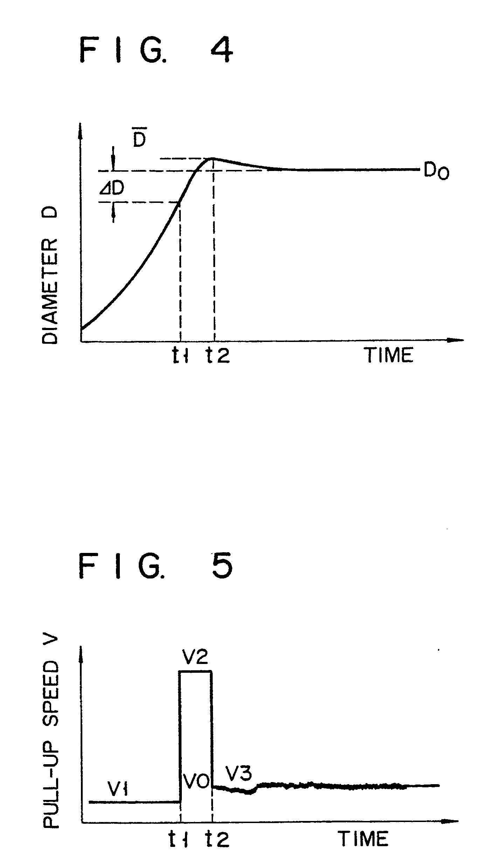

It will now be described how the apparatus of Figs. 1 and 2 is operated to manufacture a single crystal, with reference to Figs. 3 - 5. Fig. 3 is a flow chart; Fig. 4 shows how the diameter of the crystal changes with time; and Fig. 5 illustrates how the pull-up speed is changed with time.

First, the rod 22 with a seed crystal at its lower end is pulled from the crucible 14 at speed $V_1$. When the program stored in the ROM 44 starts running, the CPU 42 starts operating. Its operation cycle (several seconds to one minute) is determined by the timer 46. In step P1, mode "F = 1" is input. In step P2, the diameter of the crystal measured by the diameter measuring device 32 is read in CPU 42. It is checked in step P3 what flag is set. Since F = 1, the operation branches to step P4. In step P4 it is determined whether or not the measured diameter D is equal to or greater than $D_0$ - $\Delta D$. If D < $D_0$ - $\Delta D$, the operation returns to step P2, whereby the speed at which the rod 22 is being pulled up is still $V_1$ as shown in Fig. 5. Step P3 is repeated in every operation cycle of CPU 42. When the diameter D becomes equal to or greater than $D_0 - \Delta D$ upon lapse of time $t_1$, the answer imposed in step P4 is "YES". The operation proceeds to step P5, in which speed $V_2$ is written in CPU 42 as shown in Fig. 5. In step P6, the mode is changed to "F = 2".

In the next operation cycle of CPU 42, D is written in RAM 40 in step $P_2$. In step $P_3$ it is checked what flag is set. Since F = 2, the operation proceeds to step P7, in which it is determined whether or not diameter D is the peak value $\overline{D}$. If D has not reached $\overline{D}$, the operation returns to step P2. Since speed $V_2$ is higher than speed $V_1$, the speed of the growth of the crystal is lowered. Thereafter, the diameter D reaches the peak value $\overline{D}$, whereby the answer asked in step P7 is "YES". The operation then proceeds to step P8. In step P8, the third pull-up speed $V_3$ is input to CPU 42. This speed $V_3$ is of the initial value $V_0$. Further, the control target diameter $D_i$ is set to be peak value $\overline{D}$. In step P9, the mode is changed to "F = 3". The operation returns to step P2.

In the next operation cycle of CPU 42, D is written in CPU 42. In step P3, it is checked what flag is set. Since F = 3, the operation goes to step P10, in which it is decided whether or not $D_i$ is nearly equal to $D_0$. Since $D_i$ equals to $\overline{D}$ and greater than $D_0$, the answer is "NO". Therefore, step P11 is carried out, thereby correcting the target value $D_i$ according to the equation (1). Thereafter, in step P12, the deviation allowance $\Delta V$ is calculated by PID method. $V_3$ is therefore set to $V_0 + \Delta V$ so that D may equal $D_i$. In step P13, it is determined whether or not the single crystal has been pulled out of the crucible 12. If the answer is "NO", the operation returns to step P2. Then, the diameter of the trunk of the single crystal is controlled again.

The flag indicating that the crystal has been pulled out of the crucible 14 is set when the length of the crystal reaches a predetermined value. The length of the cyrstal is measured by a measuring device (not shown). Until this flag is set, step P12, i.e., the PID process, is repeated. The control target value $D_i$ gradually decreases as step P11 is repeated. When $D_i$ becomes nearly equal to $D_0$, the answer imposed in step P10 is "YES". Then, the operation jumps to step P12 over step P11. Step P12 is repeated until the flag is set in step P13. The program in CPU 42 then stops running.

Ten single crystals of silicon were manufactured by means of the apparatus according to the invention. The crucible 12 was made of quartz and had an inner diameter of 300 mm. About 5 Kg of silicon was put into the crucible 12 and heated by the heater 16 until it was melted. Speed $V_1$, speed $V_2$, and speed $V_0$ (initial value) input to the microcomputer 38 were 25 mm/hour, 200 mm/hour and 60 mm/hour, respectively. The target diameter $D_0$ of 80 mm and the deviation allowance $\Delta D$ of 10 mm had been input to the microcomputer 38. Each single crystal was made in the following manner.

The pull rod 22 with a seed crystal was lowered until the seed crystal was fully dipped in the molten silicon 14. Thereafter, a Dash's neck was formed. The rod 22 was pulled up at 25 mm/hour. At the same time, the temperature of the molten silicon was reduced to lower the output voltage of the pyrometer, which was used to detect said temperature, by approximately 100 microvolts. Consequently, the crystal grew, forming its shoulder.

Thirty minutes ($t_1$) after the start of the pulling of the rod 22, the crystal had a diameter of 70 mm and the pull-up speed had increased to 200 mm/hour. Upon a lapse of 3 minutes, the peak value $\overline{D}$ was reached and the pull-up speed was reduced to 60 mm/hour. Thereafter, the diameter of the crystal was controlled by the PID method, and a single crystal of silicon, about 4 Kg, was manufactured.

The ten cyrstals had no concaves or projections in their shoulders. Their trunks had a diameter of $80 \pm 0.4$ mm. It was found that the diameter of each crystal and the shape of the shoulder thereof were automatically controlled to become substantially identical with the designed shape and designed diameter. Hence, the yield was good.

**Claims**

1. An apparatus for manufacturing a single crystal having a diameter DO by a Czochralski method, comprising:

   drive means (24, 52) for pulling up the crystal from a crucible;

   measuring means (30, 32) for measuring an actual diameter D of the crystal (20) being pulled up from the crucible (12);

   timer (46);

   control means (38) connected to said drive means, said measuring means and said timer, for controlling the pull-up speed of the crystal (20), wherein

   (i) said timer (46) defines one control cycle period;

   (ii) said control means (38) stores therein the target diameter DO, for performing a pull-up control processing in synchronism with every one control cycle period in such a manner that, when the measured diameter D of the crystal being pulled up deviates from said target diameter DO, said drive means (24, 52) is controlled to change the crystal pull-up speed thereof by gradually correcting a control target value Di until the value Di reaches the target value DO; and

(iii) said control means (38) comprises,

first speed setting means (60) for setting a speed V1 at which the drive means is to pull up the crystal,

target diameter setting means (66) for setting the target diameter DO,

second speed setting means (64) for setting a speed V2 at which said drive means is to pull up the crystal,

first detecting means (62) for detecting that the measured diameter D exceeds a value DO - ΔD, where ΔD is a predetermined value, and for outputting a first detection signal indicating that D exceeds said value,

third speed setting means (72) for setting a speed V3 at which said drive means is to pull up the crystal, and for controlling the speed V3 so that the diameter D may equal to a control target value Di,

second detecting means (70) for detecting that the measured diameter D reaches a peak value $\overline{D}$ and outputting a second detection signal indicating that $D = \overline{D}$,

correction means (68) for setting the peak value $\overline{D}$ as the initial value for the control target value Di and for gradually correcting the control target value Di until the value Di reaches the target diameter DO, and

switching means (76) for supplying said drive means with a signal representing the speed V2 in response to the first detection signal and a signal representing the speed V3 in response to the second detection signal.

2. The apparatus according to claim 1, characterized in that said control means comprises a digitial microcomputer.

3. The apparatus according to claim 1, characterized in that said peak value $\overline{D}$, serving as the initial value of the control target value Di, is greater than the target diameter DO.

4. The apparatus according to claim 3, characterized in that said correction means (68), in use, gradually decreases the control target value Di, once at the end of every control cycle period, until it reaches the target diameter DO.

**Revendications**

1. Appareil destiné à fabriquer un monocristal possédant un diamètre DO, en recourant à un procédé de Czochralski, comprenant :

des moyens d'entraînement (24, 52) destinés à retirer le cristal d'un creuset;

des moyens de mesure (30, 32) destinés à mesurer un diamètre réel D du cristal (20) en cours de retrait du creuset (12);

un générateur de rythme (46);

un moyen de commande (38) relié auxdits moyens d'entraînement, auxdits moyens de mesure et audit générateur de rythme, destiné à régler la vitesse de retrait du cristal (20), dans lequel

(i) ledit générateur de rythme (46) définit une période de cycles de commande;

(ii) ledit moyen de commande (38) mémorise en son sein le diamètre-cible DO afin de mettre en oeuvre un traitement de commande de retrait en synchronisme avec chacune des périodes de cycles de commande, de telle sorte que, lorsque le diamètre mesuré D du cristal en cours de retrait dévie dudit diamètre-cible DO, lesdits moyens d'entraînement (24, 52) sont commandés pour modifier leur vitesse de retrait du cristal, en corrigeant progressivement une valeur-cible de réglage Di jusqu'à ce que la valeur Di atteigne la valeur-cible DO; et

(iii) ledit moyen de commande (38) comprend:

un premier moyen de réglage de vitesse (60) destiné à régler une vitesse V1 à laquelle les moyens d'entraînement sont censés retirer le cristal;

un moyen de réglage (66) de diamètre-cible, destiné à régler le diamètre-cible DO;

un deuxième moyen de réglage de vitesse (64) destiné à régler une vitesse V2 à laquelle lesdits moyens d'entraînement sont censés retirer le cristal;

un premier moyen de détection (62) destiné à détecter le fait que le diamètre mesuré D dépasse une valeur DO - ΛD, où ΛD représente une valeur prédéterminée, et dans le but de sortir un premier signal de détection indiquant que D dépasse ladite valeur;

un troisième moyen de réglage de vitesse (72) destiné à régler une vitesse V3 à laquelle lesdits moyens d'entraînement sont censés retirer le cristal et destiné à régler la vitesse V3 de telle sorte que le diamètre D puisse égaler une valeur-cible de commande Di;

un second moyen de détection (70) destiné à détecter le fait que le diamètre mesuré D atteint une valeur maximale D et destiné à sortir un second signal de détection indiquant que D = D;

un moyen de correction (68) destiné à régler la valeur maximale D comme étant la valeur initiale pour la valeur-cible de commande Di et destiné à corriger progressivement la valeur-cible de commande Di jusqu'à ce que la valeur Di atteigne le diamètre-cible DO; et

un moyen de commutation (76) destiné à acheminer auxdits moyens d'entraînement un signal représentant la vitesse V2 en réponse au premier signal de détection, ainsi qu'un signal représentant la vitesse V3 en réponse au second signal de détection.

2. Appareil selon la revendication 1, caractérisé en ce que ledit moyen de commande comprend un microordinateur numérique.

3. Appareil selon la revendication 1, caractérisé en ce que ladite valeur maximale D servant de valeur initiale pour la valeur-cible de commande Di, est supérieure au diamètre-cible DO.

4. Appareil selon la revendication 3, caractérisé en ce que ledit moyen de correction (68), lors de la mise en service, diminue progressivement la valeur-cible de commande Di, une fois à la fin de chaque période de cycles de commande, jusqu'à ce qu'elle atteigne le diamètre-cible DO.

**Patentansprüche**

1. Vorrichtung zur Herstellung eines Einkristalls eines Durchmessers DO nach einem Czochralski-Verfahren, umfassend:

eine Antriebseinrichtung (24, 52) zum Hochziehen des Kristalls aus einem (Schmelz-)Tiegel,

eine Meßeinrichtung (30, 32) zum Messen eines tatsächlichen Durchmessers D des aus dem Tiegel (12) hochgezogenen Kristalls (20),

einen Zeitgeber (46),

eine mit der Antriebseinrichtung, der Meßeinrichtung und dem Zeitgeber verbundene Steuereinheit (38) zum Steuern der Hochziehgeschwindigkeit des Kristalls (20), wobei

(1) der Zeitgeber (46) eine Steuerzyklus- oder -taktperiode definiert,

(2) die Steuereinrichtung (38) den Zieldurchmesser DO speichert zwecks Durchführung einer Hochzieh-Steuerverarbeitung in Synchronismus mit jeder Steuertaktperiode in der Weise, daß dann, wenn der gemessene Durchmesser D des hochgezogenen Kristalls vom Zieldurchmesser DO abweicht, die Antriebseinrichtung (24, 52) durch allmähliche Korrektur einer Steuerzielgröße Di zur Änderung ihrer Kristall-Hochziehgeschwindigkeit (an)gesteuert wird, bis die Größe Di die Zielgröße DO erreicht, und

(3) die Steuereinheit (38) umfaßt

eine erste Geschwindigkeitseinstelleinheit (60) zum Einstellen einer Geschwindigkeit V1, mit welcher die Antriebseinrichtung den Kristall hochziehen soll,

eine Zieldurchmesser-Einstelleinheit (66) zum Einstellen des Zieldurchmessers DO,

eine zweite Geschwindigkeitseinstelleinheit (64) zum Einstellen einer Geschwindigkeit V2, mit welcher die Antriebseinrichtung den Kristall hochziehen soll,

eine erste Detektoreinheit (62) zum Detektieren oder Erfassen, daß der gemessene Durchmesser D eine Größe DO - ΔD, mit ΔD gleich einer vorbestimmten Größe, übersteigt, und zum Ausgeben eines ersten Detektionssignals zum Anzeigen, daß D diese Größe übersteigt,

eine dritte Geschwindigkeitseinstelleinheit (72) zum Einstellen einer Geschwindigkeit V3, mit welcher die Antriebseinrichtung den Kristall hochziehen soll, und zum Steuern oder Regeln der Geschwindigkeit V3 in der Weise, daß der Durchmesser D sich an eine Steuerzielgröße Di angleichen kann,

eine zweite Detektoreinheit (70) zum Detektieren oder Erfassen, daß der gemessene Durchmesser D eine Spitzengröße $\overline{D}$ erreicht, und zum Ausgeben eines zweiten Detektionssignals zum Anzeigen, daß D = $\overline{D}$,

eine Korrektureinheit (68) zum Einstellen bzw. Vorgeben der Spitzengröße $\overline{D}$ als Anfangsgröße für die Steuerzielgröße Di und zum allmählichen Korrigieren der Steuerzielgröße Di, bis die Größe Di den Zieldurchmesser DO erreicht, und

eine Umschalteinheit (76) zum Beschikken der Antriebseinrichtung mit einem die Geschwindigkeit V2 repräsentierenden Signal in Abhängigkeit vom ersten Detektionssignal und einem die Geschwindigkeit V3 repräsentierenden Signal in Abhängigkeit vom zweiten Detektionssignal.

2. Vorrichtung nach Anspruch 1, dadurch gekennzeichnet, daß die Steuereinheit einen digitalen Mikrorechner umfaßt.

3. Vorrichtung nach Anspruch 1, dadurch gekennzeichnet, daß die als Anfangsgröße der Steuerzielgröße Di dienende Spitzengröße $\overline{D}$ größer

ist als der Zieldurchmesser DO.

4. Vorrichtung nach Anspruch 3, dadurch gekennzeichnet, daß die Korrektureinheit (68) im Betrieb jeweils einmal am Ende jeder Steuertaktperiode die Steuerzielgröße Di allmählich verkleinert, bis sie den Zieldurchmesser DO erreicht.

F I G. 1

EP 0 134 680 B1

# FIG. 2

# F I G. 3

START

F = 1   P1

MEASURE DIAMETER   P2

CHECK FLAG ?   P3

F=1   F=3   F=2

P4   $D \geq D_0 - \Delta D$ ?   NO

P7   PEAK VALUE REACHED ?   NO

P10   $D_i = D_0$ ?   YES   NO

YES   YES

P5   SET 2ND PULL-UP SPEED

P8   SET 3RD PULL-UP SPEED

P11   CORRECT $D_i$

P6   F = 2

P9   F = 3

P12   CALCULATE DIAMETER CONTROL VALUE

P13   IS FLAG SET ?   NO

YES

END

# F I G.  4

# F I G.  5